# EUROPÄISCHE PATENTSCHRIFT

(11) **EP 0 601 291 B1**
(45) Veröffentlichungstag und Bekanntmachung des Hinweises auf die Patenterteilung: **16.12.1998**
(21) Anmeldenummer: 93115073.4
(22) Anmeldetag: 20.09.1993
(51) Int. Cl.: G01R 15/00

(54) **Hochspannungstransformator**
High voltage transformer
Transformateur haute tension

(30) Priorität: 11.12.1992 DE 9216908 U
(43) Veröffentlichungstag der Anmeldung: 15.06.1994
(73) Patentinhaber: JENBACHER ENERGIESYSTEME AG, A-6200 Jenbach (AT)
(72) Erfinder: Kraus, Markus, A-6200 Jenbach (AT)
(74) Vertreter: Torggler, Paul, Dr.

(56) Entgegenhaltungen:
- DE-A- 1 466 677
- DE-U- 8 704 976
- PATENT ABSTRACTS OF JAPAN vol. 5, no. 202 (P-95)(874) 22. Dezember 1981 & JP-A-56 124 059 (MITSUBISHI) 29. September 1981
- EDN Bd. 12, Nr. 4 , April 1967 Seite 78. ROSE 'an exponential meter shunt?'

## Beschreibung

Die Erfindung betrifft einen Hochspannungstransformator, insbesondere Zündspule für eine Brennkraftmaschine, mit einem eine Hochspannung gegenüber einem Referenzpotential, insbesondere Masse, führenden Leiterabschnitt und mit mindestens einer in der Nähe des Leiterabschnittes angeordneten, von diesem galvanisch getrennten Leiterfläche, an der eine in Abhängigkeit von der Hochspannung variierende Spannung zur Verfügung steht.

Zur Messung der von einer Zündspule über ein Kabel an eine Zündkerze abgegebenen Hochspannung ist bereits eine Meßzange bekannt, die auf die Außenhülle der die Hochspannung führenden Leitung aufgeklemmt werden kann. Im aufgeklemmten Zustand umgeben zwei Leiterflächen der Meßzange das Hochspannungskabel. Die Leiterflächen befinden sich im elektrischen Feld, das den die Hochspannung führenden Leiterabschnitt umgibt. Die Leiterflächen der Meßzange sind über einen Kondensator an die Masse angekoppelt. Dieser Kondensator bildet zusammen mit der zwischen der Leiterfläche und dem Hochspannungs-Leiterabschnitt bestehenden Kapazität einen kapazitiven Spannungsteiler, der es erlaubt, an einer mit der Leiterfläche verbundenen Leitung eine Meßspannung gegenüber Masse abzugreifen, die zur Hochspannung proportional ist. Nachteilig an der bekannten Meßzange ist die Tatsache, daß diese in Abhängigkeit von dem das Hochspannungskabel umgebenden Dielektrikum (isolierende Kabelhülle) und dessen Durchmesser unterschiedliche Meßergebnisse liefert. Außerdem verfälschen Verschmutzungen und nicht immer gleiches Aufklemmen der Meßzange auf das Hochspannungskabel das Meßergebnis. Bei sogenannten Integralzündspulen, an denen ein Zündkerzenstecker ohne Zwischenschaltung eines Kabels direkt angeschlossen ist, kann mit der bekannten Meßzange überhaupt keine Messung vorgenommen werden.

Es wurde daher bereits auch vorgeschlagen (DE-A-4040236), eine Leiterfläche in der Nähe des Hochspannungs-Leiterabschnittes, jedoch galvanisch getrennt von diesem, an der Zündspüle anzubringen und damit die relative Lage von Leiterabschnitt und Leiterfläche festzulegen. Messungen haben jedoch ergeben, daß die an der Leiterfläche abgreifbare relativ niedrige Spannung die eigentlich zu messende Hochspannung nicht besonders genau wiedergibt.

Aufgabe der Erfindung ist es daher, einen kompakten Hochspannungstransformator, insbesondere Zündspule für eine Brennkraftmaschine, zu schaffen, der eine einfache und genaue Messung der von ihm abgegebenen Hochspannung ermöglicht.

Dies wird erfindungsgemäß dadurch erreicht, daß zwischen der Leiterfläche und einem Meßausgang ein nichtlineares elektrisches Übertragungsglied zwischengeschaltet ist, welches am Meßausgang einen im wesentlichen linearen Zusammenhang zwischen Hochspannung und Ausgangsspannung liefert.

Die Erfindung beruht auf der Erkenntnis, daß zwischen der Hochspannung und der an der Leiterfläche zur Verfügung stehenden Spannung ein nichtlinearer Zusammenhang besteht, der durch Zwischenschaltung eines absichtlich nichtlinearen Übertragungsgliedes zwischen Leiterfläche und Meßausgang gezielt verändert bzw. korrigiert werden kann. Besonders vorteilhaft und angestrebt ist natürlich ein möglichst linearer Zusammenhang zwischen der Hochspannung und der an der Leiterfläche abgegriffenen Spannung, wozu eine bevorzugte Ausführungsform der Erfindung vorsieht, daß das nichtlineare Übertragungsglied eine Linearisierungsstufe ist, die den zunächst nichtlinearen Zusammenhang zwischen der Hochspannung und der an der Leiterfläche abgegriffenen Spannung kompensiert und am Meßausgang einen im wesentlichen linearen Zusammenhang zwischen Hochspannung und Meßspannung liefert.

In der Praxis kann man die dem Übertragungsglied zugeführte Spannung an einem kapazitiven Spannungsteiler abgreifen, der durch die zwischen Hochspannungs-Leiterabschnitt und Leiterfläche gebildete Kapazität einerseits und einem an das Referenzpotential (Masse) angeschlossenen Kondensator andererseits gebildet ist. Eine bevorzugte Ausführungsform der Erfindung sieht daher vor, daß die Leiterfläche über einen Kondensator mit dem Referenzpotential (Masse) verbunden ist (sind) und eine am Kondensator abgegriffene Spannung dem übertragungsglied als Eingangsspannung zugeführt ist und die Meßspannung zwischen Meßausgang und Referenzpotential (Masse) anliegt. Grundsätzlich wäre es denkbar, einen solchen Kondensator und das Übertragungsglied außerhalb des Hochspannungstransformators (Zündspule) anzuordnen. Im Hinblick auf geringere kapazitive Störungen ist es jedoch günstiger, wenn der Kondensator und das Übertragungsglied direkt in bzw. am Hochspannungstransformator (Zündspule) befestigt ist.

Mit den erfindungsgemäßen Zündspulen ist auch bei mehreren Zündspulen an einer Brennkraftmaschine eine ständige Überwachung bzw. Aufzeichnung des Hochspannungsverlaufs möglich. Durch die genaue Messung kann einerseits auf den Zustand der Zündspule und andererseits auf den der Zündkerze geschlossen werden, ohne die Brennkraftmaschine abschalten zu müssen. Dies ist vor allem bei großen stationären Brennkraftmaschinen von wesentlicher Bedeutung.

Weitere Vorteile und Einzelheiten der Erfindung werden anhand der nachfolgenden Figurenbeschreibung näher erläutert. Es zeigen die
Fig. 1 einen axialen Längsschnitt durch eine Zündspule, wobei die in Fig. 1 hinter dem Hochspannungs-Leiterabschnitt liegende Leiterfläche in einer Ansicht dargestellt ist und das Übertragungsglied außerhalb liegt,
die Fig. 2 einen Schnitt gemäß der Linie A-A der Fig. 1,
die Fig. 3 ein elektrisches Schaltbild der in Fig. 1 dargestellten Zündspule samt übertragungsglied,
die Fig. 4 die Abhängigkeit der an der Leiterfläche zur Verfügung stehenden Spannung U_{E} und der Meßspannung U_{A} in Abhängigkeit von der Hochspannung U₂ und
Fig. 5 eine weitere Ausführungsform der erfindungsgemäßen Zündspule mit integriertem übertragungsglied.

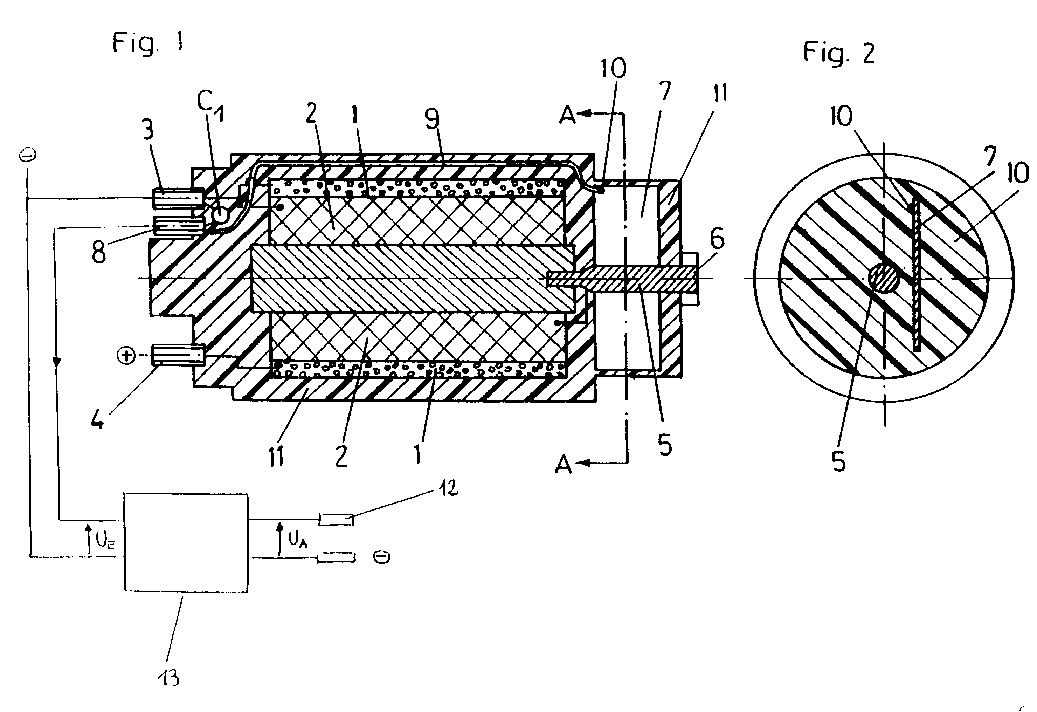

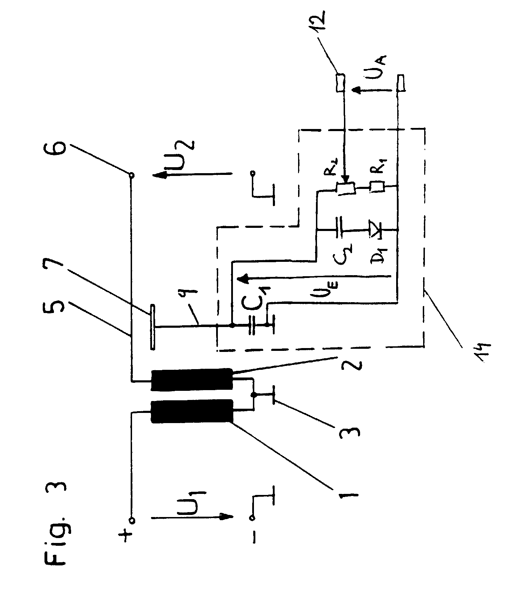

Die in den Fig. 1 und 2 dargestellte und anhand der Fig. 3 näher erläuterte Zündspule weist eine Primärwicklung 1 und eine hochspannungsseitige Sekundärwicklung 2 auf. Über einen ersten Anschluß 4 kann eine Primärspannung U₁ an die Primärspule 1 angelegt werden, wobei das zweite Ende der Primärspule mit einem zweiten Anschluß 3 (Masseanschluß) der Zündspule verbunden ist. Dieser Masseanschluß ist außerdem mit dem einen Ende der Sekundärwicklung 2 verbunden. Durch die Spannung U₁ wird in der Sekundärwicklung 2 eine wesentlich höhere Hochspannung U₂ induziert, die über den Leiterabschnitt 5 an den dritten Anschluß 6 (Hochspannungsanschluß) der Zündspule gelangt. Zwischen diesem Hochspannungsanschluß 6 (bzw. dem Leiterabschnitt 5) und Masse steht die für die Auslösung eines Zündfunkens einer nicht dargestellten Zündkerze nötige Hochspannung zur Verfügung.

In der Nähe des Leiterabschnitts 5 ist eine von diesem galvanisch getrennte Leiterfläche 7 angeordnet, welche ständig in fester räumlicher Relativlage zu dem die Hochspannung führenden Leiterabschnitt 5 in die Zündspule eingebaut ist. Die Zündspule weist einen vierten Anschluß 8 auf, der über die Verbindungsleitung 9 und die Anschlußstelle 10 elektrisch mit der Leiterfläche 7 verbunden ist. Die Leiterfläche 7 ist über einen Kondensator C₁, der ebenfalls in die Zündspule eingebaut ist, mit dem Referenzpotential (Masseanschluß 3) verbunden. Damit ergibt sich der in Fig. 3 ersichtliche kapazitive Spannungsteiler mit zwei definierten Kapazitäten. Die eine wird durch den Leiterabschnitt 5 und die im Bereich von dem diesen umgebenden elektrischen Feld angeordnete Leiterfläche 7 gebildet. Die andere Kapazität wird durch den Kondensator C₁ gebildet, dessen Kapazität beispielsweise im NanoFarad-Bereich liegen kann. Über ein hochohmiges Spannungsmeßgerät (beispielsweise einen Oszillographen mit 10 MΩ und einer kleinen Kapazität von beispielsweise 50 pF) kann die mit der Hochspannung U₂ variierende Spannung U_{E} gemessen werden, welche günstigerweise unter 50 Volt liegt.

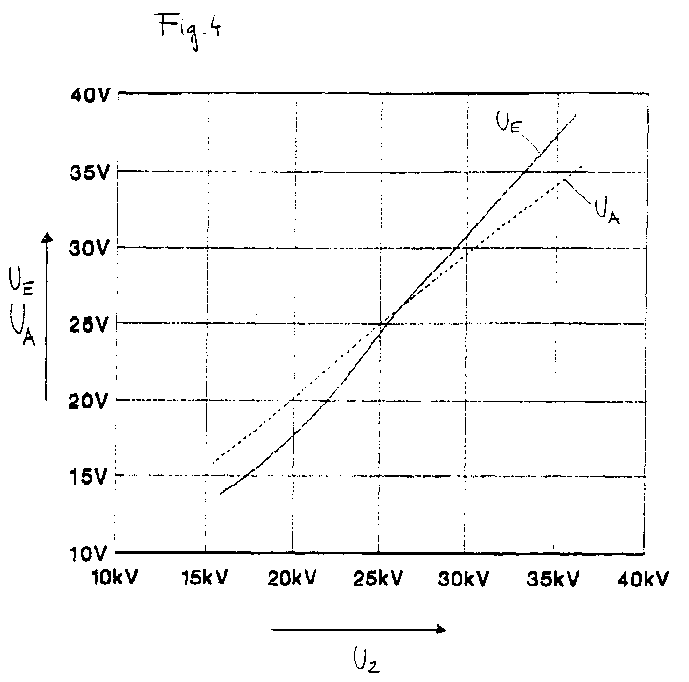

Messungen haben gezeigt, daß die an der Leiterfläche 7 bzw. am Kondensator C₁ abgreifbare Spannung U_{E} nicht ganz zur Hochspannung U₂ proportional ist, sondern beispielsweise qualitativ den in Fig. 4 mit einer ausgezogenen Linie dargestellten Verlauf aufweist. Um diesen Verlauf zu linearisieren, ist erfindungsgemäß elektrisch zwischen dem Leiterabschnitt 7 und dem Meßausgang 12 ein nichtlineares elektrisches Übertragungsglied 13 zwischengeschaltet, welches am Meßausgang 12 eine mit der Hochspannung U₂ im wesentlichen im linearen Zusammenhang stehende Ausgangsspannung U_{A} liefert. Diese Ausgangsspannung U_{A} ist in Fig. 4 mit einer strichlierten Linie dargestellt.

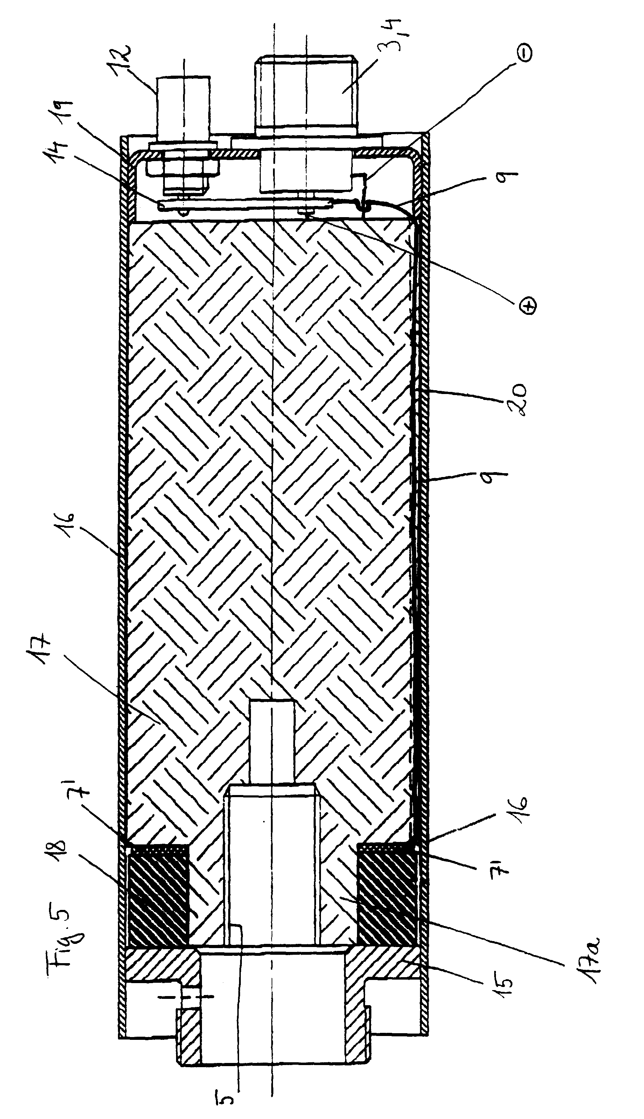

Ein möglicher Aufbau des nichtlinearen Übertragungsgliedes (Linearisierungsstufe) ist in Fig. 3 dargestellt, wobei die Bauteile C₂, D₁, R₁ und R₂ das nichtlineare Übertragungsglied bilden. Diese Bauteile können zusammen mit dem Abschlußkondensator C₁, an dem die Spannung U_{E} abgreifbar ist, auf einer gemeinsamen Platine angeordnet sein, die wie später anhand Fig. 5 erläutert werden wird, direkt im Zündspulengehäuse untergebracht werden kann.

Die nichtlineare Komponente des Übertragungsgliedes wird im wesentlichen durch die Zenerdiode D₁ gebildet, welche erst bei einer einer Hochspannung von etwa 24kV entsprechenden Niederspannung allmählich leitend wird und dabei den Kondensator C₂ den Kondensator C₁ parallel schaltet. Es handelt sich also um eine Art Zweistufenlinearisierung, die jedoch völlig ausreicht, um einen im wesentlichen linearen Zusammenhang zwischen der Meßspannung U_{A} und der Hochspannung U₂ zu erreichen. Anstelle der Zenerdiode sind grundsätzlich auch andere im Stromdurchlaßverhalten spannungsabhängige Einheiten denkbar.

Ausgangsseitig weist das Übertragungsglied eine Abgleicheinrichtung zum Kalibrieren der am Meßausgang 12 abgegriffenen Meßspannung U_{A} auf. Beim gezeigten Ausführungsbeispiel wird diese Abgleicheinrichtung von den Widerständen R₁ und R₂ gebildet, wobei der Widerstand R₂ als Potentiometer ausgeführt ist. Der Abgleich ist theoretisch auch durch einen verstellbaren Kondensator C₁ möglich, welcher das Spannungsteilerverhältnis des kapazitiven Spannungsteilers verändern kann. Im gewünschten Kapazitätsbereich sind jedoch fein einstellbare Kondensatoren, beispielsweise Drehkondensatoren nur schwer erhältlich, sodaß der Abgleich über die gezeigten Widerstände R₁ und R₂ die einfachere Lösung darstellt.

Bei dem in den Fig. 1 und 2 dargestellten Ausführungsbeispiel sind die Primär- und Sekundärwicklungen 1,2, der die Hochspannung führende Leiterabschnitt 5 sowie die Leiterfläche 7 und der Kondensator C₁ mit einer aushärtbaren, elektrisch isolierenden Masse, beispielsweise einem Epoxidharz, vergossen. Durch das Miteingießen der Leiterfläche 7 kann bereits beim Herstellungsprozeß eine definierte räumliche Relativlage der Leiterfläche 7 zum Hochspannungs-Leiterabschnitt 5 festgelegt werden, die auch bei rauhen Einsatzbedingungen exakt erhalten bleibt. Auch der Kondensator C₁ kann durch das Eingießen geschützt werden. Grundsätzlich ist es jedoch auch denkbar, den Kondensator außerhalb der vergossenen Zündspule anzuordnen. Es ist eine ebene Leiterfläche aus elektrisch leitendem Material, beispielsweise eine Kupferfläche einer Printplatte, vorgesehen.

In Fig. 5 ist ein weiteres bevorzugtes Ausführungsbeispiel des erfindungsgemäßen Hochspannungstransformators (Zündspule) gezeigt, wobei die das Übertragungsglied und den Kondensator C₁ aufweisende Platine 14 (vergl.Fig.3) in der Zündspule selbst integriert ist.

Im Gegensatz zu dem in den Fig. 1 und 2 dargestellten Ausführungsbeispiel ist die Leiterfläche 7' nicht eingegossen, sondern eingepreßt. Zur Herstellung der in Fig. 5 dargestellten Zündspule wird ein Abschlußstück 15 in eine Metallhülse 16 von zylindrischer Gestalt eingeschweißt. Auf einen im Durchmesser gegenüber dem übrigen Isolationskörper 17 reduzierten Bereich 17a ist eine ringförmige Leiterfläche 7' aus Kupfer aufgeschoben, darauffolgend ist ein Haltering 18 aus Polyamid oder Teflon aufgeschoben. zwischen dem Haltering 18 und dem Abschlußstück 15 kann noch ein nicht dargestellte O-Ring zum Ausgleich thermischer Längenänderungen vorgesehen sein. Der Zündspulenkörper 17 samt dem Leiterflächen-Ring 7' und dem Haltering 18 wird dann in Fig. 5 von rechts in die Metallhülse 16 eingeschoben und zwar bis zum Abschlußstück 15. Hierauf wird der die Elektronikplatine 14 und die Anschlüsse 3,4 und 12 tragende Deckel 19 eingepreßt oder alternativ eingeschraubt. Die Anschlüsse 3 und 4 sind zu einem Kombinationsanschluß zusammengefaßt.

Von dem Leiterflächen-Ring 7' geht eine Verbindungsleitung 9 in einer Nut 20 im Isolationskörper 17 der Zündspule bis zur Elektronikplatine 14, deren Aufbau beispielsweise dem in Fig. 3 entsprechen kann.

Die Erfindung ist nicht auf die dargestellten Ausführungsbeispiele beschränkt. Beispielsweise kann sie auch bei einem anderen Hochspannungstransformator als einer Zündspule eingesetzt werden. Der Meßausgang 8 braucht nicht als Anschlußklemme an der Zündspule bzw. dem Hochspannungstransformator ausgebildet sein. Es wäre grundsätzlich auch denkbar, daß das Verbindungskabel 9 nach außen geführt ist und in ein externes übertragungsglied mündet. Neben der einen ebenen und kreisringförmigen Leiterfläche sind noch andere Leiterflächenkonfigurationen durchaus denkbar und möglich. Beispielsweise sind auch zwei Leiterflächen möglich, die im Querschnitt gesehen den Hochspannungs-Leiterabschnitt jeweils halbkreisförmig umgeben. Auch sind nicht dargestellte Halteelemente zwischen Hochspannungs-Leiterabschnitt und der bzw. den Leiterflächen möglich, die bei einem Vergießen mit einer aushärtbaren Masse eine definierte Relativlage zwischen Leiterabschnitt und Leiterfläche sicherstellen.

## Patentansprüche

1. Hochspannungstransformator, insbesondere Zündspule für eine Brennkraftmaschine, mit einem eine Hochspannung gegenüber einem Referenzpotential, insbesondere Masse, führenden Leiterabschnitt (5) und mit mindestens einer in der Nähe des Leiterabschnittes (5) angeordneten, von diesem galvanisch getrennten Leiterfläche (7;7') an der eine in Abhängigkeit von der Hochspannung (U₂) variierende Spannung (U_{E)} zur Verfügung steht, dadurch gekennzeichnet, daß zwischen der Leiterfläche (7;7') und einem Meßausgang (12) ein nichtlineares elektrisches Übertragungsglied (13) zwischengeschaltet ist, welches am Meßausgang (12) einen im wesentlichen linearen Zusammenhang zwischen Hochspannung (U₂) und Ausgangsspannung (U_{A}) liefert.

2. Hochspannungstransformator nach Anspruch 1, dadurch gekennzeichnet, daß die Leiterfläche (7;7') über einen Kondensator (C₁) mit dem Referenzpotential verbunden ist und die variierende Spannung (U_{E}) am Kondensator (C₁) abgegriffen und dem Übertragungsglied (13) als Eingangsspannung zugeführt ist und daß die Meßspannung (U_{A}) zwischen Meßausgang (12) und Referenzpotential anliegt.

3. Hochspannungstransformator nach Anspruch 1 oder 2, dadurch gekennzeichnet, daß der Kondensator (C₁) und/oder das Übertragungsglied (13) am oder im Hochspannungstransformator befestigt sind ist.

4. Hochspannungstransformator nach Anspruch 3, dadurch gekennzeichnet, daß der Kondensator C₁ und die Bauteile (C₂, D₁,R₁,R₂) des Übertragungsgliedes auf derselben Platine (14) am bzw. im Hochspannungstransformator angeordnet sind und der Meßausgang am Hochspannungstransformator angeordnet ist.

5. Hochspannungstransformator nach einem der Ansprüche 1 bis 4, dadurch gekennzeichnet, daß das nichtlineare Übertragungsglied (13) eine Linearisierungsstufe ist, die den zunächst nichtlinearen Zusammenhang zwischen der Hochspannung (U₂) und der an der Leiterfläche (7,7') abgegriffenen Spannung (U_{E}) kompensiert und am Meßausgang (12) einen im wesentlichen linearen Zusammenhang zwischen Hochspannung (U₂) und Meßspannung (U_{A}) liefert.

6. Hochspannungstransformator nach einem der Ansprüche 1 bis 5, dadurch gekennzeichnet, daß das Übertragungsglied (13) parallel zum Eingang eine Kapazität (C₂) und dazu in Serie eine im Stromdurchlaßverhalten spannungsabhängige Einheit (D₁) aufweist.

7. Hochspannungstransformator nach Anspruch 6, dadurch gekennzeichnet, daß die spannungsabhängige Einheit eine Zenerdiode (D₁) ist.

8. Hochspannungstransformator nach einem der Ansprüche 1 bis 7, dadurch gekennzeichnet, daß das Übertragungsglied (13) eine Abgleicheinrichtung (R_{,}R₂) zum Kalibrieren der am Meßausgang (12) abgreifbaren Meßspannung (U_{A}) aufweist.

9. Hochspannungstransformator nach Anspruch 8, dadurch gekennzeichnet, daß die Abgleicheinrichtung (R₁, R₂) ein ausgangsseitig im Übertragungsglied (13) angeordnetes Potentiometer (R₂) umfaßt.

10. Hochspannungstransformator nach einem der Ansprüche 1 bis 9, dadurch gekennzeichnet, daß die Leiterfläche (7') den Hochspannung führenden Leiterabschnitt (5) ringartig umgibt.

11. Hochspannungstransformator nach Anspruch 10, dadurch gekennzeichnet, daß die ringartige Leiterfläche (7') auf einem im Durchmesser gegenüber dem übrigen im wesentlichen zylindrischen Hochspannungstransformator reduzierten Bereich (17a) aufgeschoben ist.

12. Hochspannungstransformator nach Anspruch 11, dadurch gekennzeichnet, daß auf den Bereich (17a) auch ein Halterring (18) aus nichtleitendem Material, vorzugsweise aus Polyamid oder Polytetrafluoräthylen aufgeschoben ist.

13. Hochspannungstransformator nach einem der Ansprüche 1 bis 12, dadurch gekennzeichnet, daß der gesamte Hochspannungstransformator von einer vorzugsweise zylindrischen Metallhülse (16) umgeben ist.

14. Hochspannungstransformator nach Anspruch 13, dadurch gekennzeichnet, daß eine Verbindungsleitung (9) von der Leiterfläche (7') aus zwischen Metallhülse (16) und dem Isolationskörper (17) des Hochspannungstransformators zum Übertragungsglied (13) verläuft.

15. Hochspannungstransformator nach einem der Ansprüche 1 bis 3, dadurch gekennzeichnet, daß eine Verbindungsleitung (9) von der Leiterfläche (7') aus in einer Nut (20) im Isolationskörper (17) des Hochspannungstransformators zum Übertragungsglied (13) verläuft.

## Claims

1. High voltage transformer, in particular an ignition coil for a combustion engine, with a conductor section (5) carrying a high voltage with respect to a reference potential, in particular earth, and with at least one conductor surface (7; 7') in the proximity of the conductor section (5), and galvanically separated therefrom, to which a voltage (U_{E}) is applied, the variation of which is dependent upon the high voltage (U₂), characterised in that between the conductor surface (7; 7') and a test output (12) a non-linear electrical transmission element (13) is interconnected which provides a substantially linear relationship between the high voltage (U₂) and measured voltage (U_{A}) at the test output (12).

2. High voltage transformer according to claim 1, characterised in that the conductor surface (7; 7') is connected to the reference potential by means of a capacitor (C₁) and the varying voltage (U_{E}) is sensed by the capacitor (C₁) and applied to the transmission element (13) as an input voltage, and that the measured voltage (U_{A}) lies between the test output (12) and the reference potential.

3. High voltage transformer according to claim 1 or 2, characterised in that the capacitor (C₁) and/or the transmission element (13) are/is fixed onto or into the high voltage transformer.

4. High voltage transformer according to claim 3, characterised in that the capacitor C₁ and the components (C₁, D₁, R₁, R₂) of the transmission element are arranged on the same circuit board (14) on or in the high voltage transformer, and the test output is arranged on the high voltage transformer.

5. High voltage transformer according to one of claims 1 to 4, characterised in that the non-linear transmission element (13) is a linearization phase, which firstly compensates the non-linear relationship between the high voltage (U₂) and the voltage (U_{E}) sensed by the conductor surface (7, 7') and provides a substantially linear relationship between the high voltage (U₂) and measured voltage (U_{A}) at the test output.

6. High voltage transformer according to one of claims 1 to 5, characterised in that the transmission element (13) has a capacitance (C₂) parallel to the input and in addition thereto in series an element (D₁) with a voltage dependent forward transmission characteristic.

7. High voltage transformer according to claim 6, characterised in that the voltage dependent element is a Zener diode (D₁).

8. High voltage transformer according to one of claims 1 to 7, characterised in that the transmission element (13) is provided with an adjusting device (R, R₂) for calibration of the measured voltage (U_{A}) sensable at the test output (12).

9. High voltage transformer according to claim 8, characterised in that the adjusting device (R₁, R₂) comprises a potentiometer (R₂) on the output side of the transmission element (13).

10. High voltage transformer according to one of claims 1 to 9, characterised in that the conductor surface (7') surrounds the high voltage carrying conductor section (5) in a ring like manner.

11. High voltage transformer according to claim 10, characterised in that the ring-like conductor surface (7') is pushed onto an area (17a) which has a diameter which is reduced in comparison to the remaining substantially cylindrical high voltage transformer.

12. High voltage transformer according to claim 11, characterised in that a holding ring (18) of non conducting material, preferably of polyamide or polytetrafluorethylene, is also pushed onto the area (17a).

13. High voltage transformer according to one of claims 1 to 12, characterised in that the entire high voltage transformer is surrounded by a preferably cylindrical metal sheath (16).

14. High voltage transformer according to claim 13, characterised in that a connecting lead (9) leads from the conductor surface (7') between the metal sheath (16) and the insulating member (17) of the high voltage transformer to the transmission element (13).

15. High voltage transformer according to one of claims 1 to 3, characterised in that a connecting lead (9) leads from the conductor surface (7') in a groove (20) in the insulating member (17) of the high voltage transformer to the transmission member (13).

## Revendications

1. Transformateur de haute tension, en particulier bobine d'allumage pour un moteur à combustion, comprenant un segment conducteur (5) conduisant une haute tension par rapport à un potentiel de référence, en particulier la masse, et comprenant au moins une surface conductrice (7 ; 7') qui est disposée à proximité du segment conducteur (5), et isolée galvaniquement de celui-ci, et au niveau de laquelle on dispose d'une tension (U_{E}) variant en fonction de la haute tension (U₂), caractérisé en ce qu'un organe de transmission (13) électrique non linéaire est intercalé entre la surface conductrice (7 ; 7') et une sortie de mesure (12), lequel organe de transmission fournit au niveau de la sortie de mesure (12) un rapport sensiblement linéaire entre la haute tension (U₂) et la tension de sortie (U_{A}).

2. Transformateur de haute tension selon la revendication 1, caractérisé en ce que la surface conductrice (7 ; 7') est reliée au potentiel de référence par un condensateur (C₁) et la tension (U_{E}) variable est prélevée au niveau du condensateur (C₁) et est transmise comme tension d'entrée à l'organe de transmission (13) et que la tension de mesure (U_{A}) se trouve entre la sortie de mesure (12) et le potentiel de référence.

3. Transformateur de haute tension selon la revendication 1 ou 2, caractérisé en ce que le condensateur (C₁) et/ou l'organe de transmission (13) sont (est) fixé(s) sur ou dans le transformateur de haute tension.

4. Transformateur de haute tension selon la revendication 3, caractérisé en ce que le condensateur (C₁) et les composants (C₂, D₁, R₁, R₂) de l'organe de transmission sont disposés sur la même platine (14) sur ou dans le transformateur de haute tension et la sortie de mesure est disposée sur le transformateur de haute tension.

5. Transformateur de haute tension selon l'une des revendications 1 à 4, caractérisé en ce que l'organe de transmission (13) non linéaire est un étage de linéarisation qui compense le rapport dans un premier temps non linéaire entre la haute tension (U₂) et la tension (U_{E}) prélevée au niveau de la surface conductrice (7, 7') et fournit au niveau de la sortie de mesure (12) un rapport sensiblement linéaire entre la haute tension (U₂) et la tension de mesure (U_{A}).

6. Transformateur de haute tension selon l'une des revendications 1 à 5, caractérisé en ce que l'organe de transmission (13) comporte, en parallèle avec l'entrée, une capacité (C₂) et en série avec celle-ci, une unité (D₁) dont le comportement de conduction du courant varie en fonction de la tension.

7. Transformateur de haute tension selon la revendication 6, caractérisé en ce que l'unité qui varie en fonction de la tension est une diode Zener (D₁).

8. Transformateur de haute tension selon l'une des revendications 1 à 7, caractérisé en ce que l'organe de transmission (13) comporte un dispositif d'équilibrage (R₁, R₂) destiné à calibrer la tension de mesure (U_{A}) pouvant être prélevée au niveau de la sortie de mesure (12).

9. Transformateur de haute tension selon la revendication 8, caractérisé en ce que le dispositif d'équilibrage (R₁, R₂) comprend un potentiomètre (R₂) disposé côté sortie dans l'organe de transmission (13).

10. Transformateur de haute tension selon l'une des revendications 1 à 9, caractérisé en ce que la surface conductrice (7') entoure en anneau le segment conducteur (5) conduisant la haute tension.

11. Transformateur de haute tension selon la revendication 10, caractérisé en ce que la surface conductrice (7') en forme d'anneau est enfilée sur une partie (17a) dont le diamètre est réduit par rapport au reste du transformateur de haute tension sensiblement cylindrique.

12. Transformateur de haute tension selon la revendication 11, caractérisé en ce qu'une bague de maintien (18) en un matériau non conducteur, de préférence en polyamide ou en polytétrafuoréthylène, est également enfilée sur la partie (17a).

13. Transformateur de haute tension selon l'une des revendications 1 à 12, caractérisé en ce que l'ensemble du transformateur de haute tension est entouré par un manchon métallique (16) de préférence cylindrique.

14. Transformateur de haute tension selon la revendication 13, caractérisé en ce qu'une ligne de raccordement (9) s'étend à partir de la surface conductrice (7'), entre le manchon métallique (16) et le corps isolant (17) du transformateur de haute tension, vers l'organe de transmission (13).

15. Transformateur de haute tension selon l'une des revendications 1 à 3, caractérisé en ce qu'une ligne de raccordement (9) s'étend à partir de la surface conductrice (7'), dans une rainure (20) dans le corps isolant (17) du transformateur de haute tension, vers l'organe de transmission (13).
